# EUROPEAN PATENT APPLICATION

(11) **EP 4 497 686 A1**
(43) Date of publication of application: **29.01.2025**
(21) Application number: 24190248.5
(22) Date of filing: 23.07.2024
(51) Int. Cl.: B64D 13/08, B64D 33/08, B64D 13/06, B64D 27/34, F28D 20/02, F28D 21/00

(54) **THERMAL MANAGEMENT SYSTEM FOR AN ELECTRIC VEHICLE**

(30) Priority: 28.07.2023 US 202318361593
(71) Applicant: Honeywell International Inc., Charlotte, NC 28202 (US)
(72) Inventor: ABUHEIBA, Ahmed, Charlotte, 28202 (US); MAHDEREKAL, Isaac, Charlotte, 28202 (US); LI, Tianlei, Charlotte, 28202 (US)
(74) Representative: Haseltine Lake Kempner LLP

(57) **Abstract**

A system comprising: a heat exchanger configured to be thermally coupled to a cooling system of an electric vehicle, wherein the cooling system is thermally coupled to at least two subsystems of a plurality of subsystems of the electric vehicle, wherein each subsystem of the at least two subsystems is configured to be maintained at a different threshold temperature level; a sealed subsystem thermally coupled to the heat exchanger; and a phase changing material (PCM) disposed within the sealed subsystem, wherein the PCM is configured to transition, via an at least partial transition between a first state of matter and a second state of matter, thermal energy between the PCM and the cooling system via the heat exchanger to maintain each subsystem of the at least two subsystems at a respective threshold temperature level.

## Description

### TECHNICAL FIELD

This disclosure relates to thermal energy management by an electric vehicle.

### BACKGROUND

An electric vehicle (e.g., an electric aircraft) may include one or more subsystems to perform one or more functions of the vehicle. The subsystems may draw power from a battery of the electric vehicle and may generate heat. The vehicle needs a cooling system to manage the temperature of components within allowable during the vehicle operation.

### SUMMARY

In general, this disclosure is directed to methods, techniques, devices, and systems for managing the thermal energy from subsystems within an electrical vehicle. Electric vehicles may include, but are not limited to, electric aircraft, electric unmanned aerial vehicles (UAVs), electrified vertical take-off and landing vehicles (e-VTOLs), electrified urban air mobility (UAM) vehicles, electric automobiles, or the like. Electrical vehicles may include subsystems configured to draw power from a power source of the electrical vehicle to perform one or more functions, e.g., navigation, propulsion, cooling, computing functions, or the like. In some examples, depending on the environment the electrical vehicle is configured to operate in, intended operations of the electrical vehicle, and/or intended cargo of the electrical vehicle, the electrical vehicle may encompass a relatively smaller volume and/or define a relatively lighter weight to better operate in a specific environment (e.g., in an urban environment) and/or to better perform the intended function (e.g., carrying passengers and/or cargo) in the specific environment.

An electric vehicle may include a cooling system such as a thermal management system (TMS) to manage temperatures of components of subsystems. The cooling system may draw power from a power source of the electric vehicle to operate and manage the temperatures of components within the electric vehicle. The cooling system manages the temperature of the components to prevent overheating of and/or damage to the components. The volume and weight required for a TMS may be dependent on the thermal power the TMS is configured to manage. For example, an electric vehicle experiencing greater thermal power may require a TMS with greater thermal management capacity. A TMS with greater thermal management capacity may require additional volume and weight allocations within an electric vehicle than another TMS with a lower thermal management capacity. A TMS with greater thermal management capacity may require increased power from the power source to manage the thermal power of an electric vehicle than a TMS with a lower thermal management capacity.

Electric vehicles may experience sudden increases in thermal power relative to an average thermal power overtime. In order to manage the sudden increases in thermal power, the TMS needs to have a thermal management capacity capable of managing the temperatures of components within the electric vehicle at the increased thermal power level. The increase in thermal management capacity of the TMS may lead to increased volume, weight, and power allocations for the cooling system within the electric vehicle, which may reduce available volume, weight, and power allocations for other components and/or subsystems of the electric vehicle.

Subsystems of an electric vehicle may need to be maintained at different temperatures. For example, a cabin of an electric vehicle may need to be maintained at a different temperature or temperature range than a power source or a computing system of the electric vehicle. TMS may maintain every component thermally coupled to the TMS at a uniform temperature. Therefore, multiple TMS or complex cooling channels may be required to maintain different components or subsystems at different temperatures, which increases the volume, weight, and power allocations for cooling systems within the electric vehicle, which reduces available volume, weight, and power allocations for other components and/or subsystems of the electric vehicle.

This disclosure describes example devices, systems, or methods for managing thermal power outputted by an electric vehicle using one or more phase changing materials (PCM). PCMs may transition at least partially from one state of matter (e.g., a solid) to another state of matter (e.g., a liquid) in response to the introduction or removal of thermal energy from the PCM. The cooling systems described herein may thermally couple components and/or subsystems of an electric vehicle with one or more PCMs to store excess thermal energy in the one or more PCMs and cool components and/or subsystems. In some examples, the cooling systems described herein may retrieve stored thermal energy from within the one or more PCMs to heat up components and/or subsystems.

The techniques, systems, and devices described in this disclosure may provide one or more advantages. PCMs may retain a higher energy density than a TMS system. Therefore, a greater quantity of thermal energy will be provided by PCMs than another TMS occupying a same volume and/or with a same weight, thereby reducing weight and/or volume allocation for a cooling system within an electric vehicle. For example, a cooling system including PCMs may occupy less volume within the electric vehicle, may be lighter, and/or may require less power to management a same amount of thermal power as one or more TMS. PCM may be thermally coupled to multiple components and/or subsystems and may maintain each component or subsystem at corresponding temperatures, without requiring multiple separate cooling systems and/or complex cooling channels, thereby reducing volume, weight, and power allocations needed to maintain components and/or subsystems at different temperatures. The use of a cooling system with one or more PCMs may allow an electric vehicle with size and weight limitations (e.g., for UAM operations) to effectively manage thermal power during the duration of a voyage without allocating significant portions of the volume, weight, and power allocations of the electric vehicle to a cooling system (e.g., one or more TMS).

In some examples, this disclosure describes a system comprising: a heat exchanger configured to be thermally coupled to a cooling system of an electrified aircraft propulsion (EAP) system, wherein the cooling system is thermally coupled to at least two subsystems of a plurality of subsystems of the EAP system, wherein each subsystem of the at least two subsystems is configured to be maintained at a different threshold temperature level; a sealed subsystem thermally coupled to the heat exchanger; and a phase changing material (PCM) disposed within the sealed subsystem, wherein the PCM is configured to transition, via an at least partial transition between a first state of matter and a second state of matter, thermal energy between the PCM and the cooling system via the heat exchanger to maintain each subsystem of the at least two subsystems at a respective threshold temperature level.

In some examples, this disclosure describes a method comprising: circulating a fluid within a cooling system of an electrified aircraft propulsion (EAP) system to extract thermal energy from each subsystem of at least two subsystems of a plurality of subsystems of the EAP system; transmitting the thermal energy from the cooling system to a heat exchanger thermally coupled to the cooling system; and storing the thermal energy in a phase changing material (PCM) disposed within a sealed subsystem thermally coupled to the heat exchanger, wherein storage of the thermal energy in the PCM at least partially transitions the PCM from a first state of matter to a second state of matter, and wherein storing the thermal energy in the PCM causes the cooling systems is configured to maintain each subsystem at a different threshold temperature level.

In some examples, this disclosure describes a system comprising: a heat exchanger configured to be thermally coupled to a cooling system of a vehicle, wherein the cooling system is thermally coupled to at least two subsystems of the vehicle, wherein the at least two subsystems comprises two or more of a battery, a propulsion subsystem, an electrical subsystem, an air conditioning (AC) subsystem, or a cabin of the vehicle, wherein each subsystem of the at least two subsystems is configured to be maintained at a different threshold temperature level; a sealed subsystem thermally coupled to the heat exchanger; and a phase changing material (PCM) disposed within the sealed subsystem, wherein the PCM is configured to transition, via an at least partial transition between a first state of matter and a second state of matter, thermal energy between the PCM and the cooling system via the heat exchanger to maintain each subsystem of the at least two subsystems at a respective threshold temperature level.

The summary is intended to provide an overview of the subject matter described in this disclosure. It is not intended to provide an exclusive or exhaustive explanation of the systems, device, and methods described in detail within the accompanying drawings and description below. Further details of one or more examples of this disclosure are set forth in the accompanying drawings and in the description below. Other features, objects, and advantages will be apparent from the description and drawings, and from the claims.

### BRIEF DESCRIPTION OF DRAWINGS

FIG. 1 is a block diagram illustrating an example electric vehicle system, in accordance with one or more techniques of this disclosure.
FIG. 2 is a block diagram illustrating an example cooling system for the electric vehicle of FIG. 1.
FIG. 3 is a block diagram illustrating the flow of energy within subsystems of the example electric vehicle of FIG. 1.
FIG. 4 is a block diagram illustrating the exchange of thermal energy between a heat exchanger and a phase changing material (PCM) within the example electric vehicle system of FIG. 1.
FIG. 5 is a graph illustrating an example thermal power on the electric vehicle of FIG. 1 over time.
FIG. 6 is a flow chart illustrating an example process of managing the thermal energy of an electric vehicle using a PCM.

### DETAILED DESCRIPTION

Electric vehicles may draw on electrical energy from an internal power source (e.g., a battery) to perform functions including, but are not limited to, navigation, propulsion, communication, or the like. Electric vehicles may include, electric aircraft, watercraft, automobiles, or the like. Electric vertical takeoff and landing vehicles (eVTOLs) may represent electric aircraft that are configured to takeoff, land, and fly using electrical energy without consuming carbon-based fuels. In some examples, an eVTOL may be configured for Urban Air Mobility (UAM). An eVTOL may, in some examples, represent an unmanned aerial vehicle (UAV), but this is not required. Some eVTOLs are operated by a human pilot aboard the aircraft. In some examples, such as during UAM operations, an electric vehicle may operate in a relatively confined environment (e.g., within an urban location). In such environments, the electric vehicle may be more limited in volume and weight than another electric vehicle operating in a less confined environment.

Components and/or subsystems within an electric vehicle may generate thermal energy as a byproduct of performing various functions. Thermal energy may be represented as a thermal power generated by the electric vehicle. The thermal power may correspond to an amount of thermal energy generated by the electric vehicle during operation. Buildup of thermal energy may lead to an increase in the temperature of components and/or subsystems, which may lead to failure and/or damage to the components and/or subsystems. A cooling system, such as a thermal management system (TMS), may regulate the temperatures of components and/or subsystems by extracting excess thermal energy from the components and/or subsystems.

While an electric vehicle may generate an average thermal power during a voyage, the electric vehicle may experience localized increases in thermal power at certain times. For example, an eVTOL may generate increased thermal power during takeoff and/or landing. The increased thermal power may be about three to four times the average thermal power. Additionally, at least some of the components and/or subsystems may need to be maintained at different temperature levels during a voyage. For example, a passenger cabin of the electric vehicle may need to be maintained at a different temperature level than a propulsion subsystem of the electric vehicle.

A TMS may define a specified thermal management capacity. In the event of localized increases in thermal power, TMS needs to be configured to manage an amount of thermal power at least equal to the localized maximum thermal power. The increased thermal management capacity may require the use of a TMS with increased volume, weight, and power requirements. In addition, the TMS constantly draws power from a power source of a vehicle to management thermal power of the electric vehicle. In some examples, where the electric vehicle has limited volume and weight allocations, such as with an eVTOL in UAM operations, the size and storage capacity of the power source of the electric vehicle may be limited. The increased volume, weight, and power consumption of a TMS configured to manage localized increases in thermal power reduces the efficiency of the cooling system and requires allocation of volume, weight, and power away from other subsystems. In some examples, an electric vehicle with a TMS with increased thermal management capacity may be slower, less maneuverable, and/or define a shorter range than an identical electric vehicle with a TMS with lower thermal management capacity.

TMS maintains all components and/or subsystems thermally coupled to the TMS at a uniform temperature. Therefore, multiple TMS or complex channels are required to maintain different components and/or subsystems of the electric vehicle at different temperature. The inclusion of multiple TMS further increases the volume, weight, and power allocations required to house a cooling system within an electric vehicle.

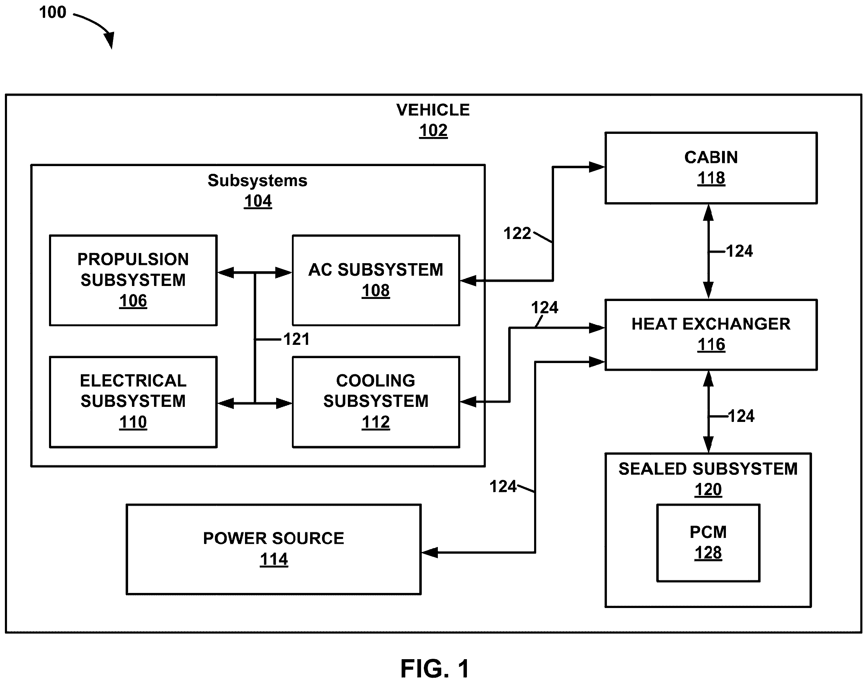

FIG. 1 is a block diagram illustrating an example electric vehicle system 100 (alternatively referred to herein as "system 100"), in accordance with one or more techniques of this disclosure. As illustrated in FIG. 1, system 100 may include a vehicle 102 including a plurality of subsystems 104, a power source 114, a cabin 118, a heat exchanger 116, and a sealed subsystem 120 containing a phase changing material (PCM) 128. Subsystems 104 may include, but are not limited to, a propulsion subsystem 106, an air condition (AC) subsystem 108, an electrical subsystem 110, and/or a cooling subsystem 112. One or more of cooling subsystem 112, power source 114, and cabin 118 may transmit excess thermal energy 124 to sealed subsystem 120 through heat exchanger 116. Heat exchanger 116 may be thermally coupled to sealed subsystem and may transmit thermal energy.

Propulsion subsystem 106 may include one or more components configured to propel vehicle 102 through an environment. Components of propulsion subsystem 106 may include, but are not limited to, motors, engines, wheels, propellers, rotors, gearboxes, drive shafts, or any other components configured to facilitate travel of vehicle 102 through an environment. In some examples, where vehicle 102 is an eVTOL, propulsion subsystem 106 may be a part of or may define an Electrified Aircraft Propulsion (EAP) system. In some examples, subsystems 104 may define an EAP system. Propulsion subsystem 106 may draw electrical energy from power source 114 to perform one or more functions to propel vehicle 102. For example, propulsion subsystem 106 may draw electrical energy from power source 114 to actuate a motor, engine, and/or a rotor to cause one or more of wheels, propellers, and/or drive shafts to rotate, thereby causing vehicle 102 to move under its own power in the environment. Propulsion subsystem 106 may generate thermal energy 121 as a byproduct of propulsion of vehicle 102.

Propulsion subsystem 106 convert electric power drawn from power source 114 into mechanical power which propels vehicle 102. A portion of the electric power drawn by propulsion subsystem 106 may be lost as thermal energy 121. Cooling subsystem 112 and heat exchanger 116 may transfer thermal energy 121 into PCM 128 within sealed subsystem 120. System 100 may maintain components of propulsion subsystem 106 at up to 60 degrees Celsius.

AC subsystem 108 may regulate an internal temperature of cabin 118 of vehicle 102. Cabin 118 may contain passengers and/or cargo which must be maintained at a specified temperature (e.g., cargo which needs to be refrigerated). AC subsystem 108 may transmit thermal energy 122 into and/or out of cabin 118 to regulate the temperature of cabin 118. AC subsystem 108 may regulate temperature of cabin 118 via air cooling/heating or via liquid cooling/heating. AC subsystem 108 may draw electrical energy from power source 114 to perform the functions attributed to it herein. AC subsystem 108 may generate thermal energy 121 as a byproduct of maintaining the temperature of cabin 118. In some examples, the temperature of cabin 118 may be directly regulated by heat exchanger 116 instead of or in addition to AC subsystem 108.

Electrical subsystem 110 may perform one or more functions of a computing system of vehicle 102 including, but are not limited to, navigation, displaying, sensing, illumination, communication, control of other subsystems, or the like. For example, electrical subsystem 110 may control propulsion subsystem 106 and/or AC subsystem 108, illuminate cabin 118, communicate with another vehicle or a base station, sense the environment surrounding vehicle 102, navigate vehicle 102 within the environment surrounding vehicle 102, displaying information to an operator, or the like. Electrical subsystem 110 may include components (e.g., wires, cables) configured to transmit electrical energy from power source 114 to any other subsystem of subsystems 104. Electrical subsystem 110 may generate thermal energy 121 as a byproduct of the performance of operations described herein. Electrical subsystem 110 may be a part of an EAP system.

Cooling subsystem 112 may regulate the temperature of components and/or subsystems within subsystems 104. Cooling subsystem 112 may be thermally coupled to other subsystems and may in turn thermally couple the other subsystems to heat exchanger 116. Cooling subsystem 112 may be a part of an EAP system and/or may be a part of a cooling system of vehicle 102. Cooling subsystem 112 may include one or more cooling channels (e.g., air cooling channels, liquid cooling channels) coupled to subsystems 104 and to heat exchanger 116. Cooling subsystem 112 may include one or more components (e.g., pumps, compressors, filters, valves) configured to circulate a first temperature moderating medium (e.g., air, another gas, water, another liquid) through cooling subsystem 112 and between subsystems 104 and heat exchanger 116. Cooling subsystem 112 may transfer thermal energy 121 from one or more of subsystems 104 to heat exchanger 116 in the form of thermal energy 124. In some examples, cooling subsystem 112 may regulate the temperature of power source 114 and/or of cabin 118 in addition to or instead of other components or subsystems of vehicle 102 as described herein.

Power source 114 may be configured to store electrical energy and may transmit electrical energy to other components and/or subsystems within vehicle 102 to cause vehicle 102 to perform any of the functions described herein. Power source 114 may be removable from vehicle 102 or may be permanently affixed to vehicle 102. Power source 114 may include, but is not limited to, a battery. The volume, weight, and storage capacity of power source 114 may be at least partially dependent on the power consumption of a cooling system of vehicle 102. For example, a cooling system with PCM 128 may consume less power during the duration of a voyage than an identical cooling system with TMS and may be power by a power source 114 with reduced volume, weight, and storage capacity. Power source 114 may be maintained at between 30 and 40 degrees Celsius. Power source 114 may transmit excess thermal energy 124 directly to heat exchanger 116, as illustrated in FIG. 1, or may transmit thermal energy 124 to cooling subsystem 112 of vehicle 102. In some examples, power source 114 may be a part of an EAP system.

Cabin 118 may house passengers and/or cargo within vehicle 102. Cabin 118 may be illuminated by electric subsystem 110. Cabin 118 may be maintained at a temperature between about 18 degrees Celsius and about 24 degrees Celsius. Cabin 118 may transmit excess thermal energy 124 directly to heat exchanger 116 and/or to cooling subsystem 112.

Heat Exchanger 116 may allow for the exchange of thermal energy 124 between subsystems 104 (e.g., via cooling subsystem 112), cabin 118, and power source 114 and sealed subsystem 120 to store excess thermal energy in PCM 128 within sealed subsystem 120. Heat exchanger 116 may facilitate the transmission of thermal energy 124 between a first temperature moderating medium within cooling subsystem 112 and/or thermally coupled to cabin 118 and/or power source 114 and a second temperature moderating medium thermally coupled to sealed subsystem 120. First temperature moderating medium and second temperature moderating medium may not be fluidically coupled to each other and may be fluidically isolated from each other.

Sealed subsystem 120 may define a vessel configured to contain PCM 128. PCM 128 may be configured to at least partially transition between states of matter to retain thermal energy 124. PCM 128 may, upon receiving thermal energy 124 from heat exchanger 116, at least partially transition from a solid state of matter towards a liquid state of matter, thereby retaining the thermal energy 124. PCM 128 may store and release thermal energy 124 in response to and to mitigate transient swings in the temperatures of components and/or subsystems of vehicle 102, as described herein. PCM 128 may include, but are not limited to, a salt hydrate, Paraffin, and water/ice mix. PCM 128 may be configured to transition between states of matter and maintain stability for up to thousands of cycles (e.g., at least about 4000 cycles). PCM 128 may include additives to inhibit supercooling of PCM 128.

PCM 128 may be recharged after receiving thermal energy 124 by cooling or otherwise extracting thermal energy 124 from PCM 128 to cause PCM 128 to revert back to an initial state of matter (e.g., to revert to a solid state of matter). PCM 128 may be recharged after or during a voyage. For example, vehicle 102 allow inflow of air around sealed subsystem 120 to cause at least partial recharge of PCM 128. Sealed subsystem 120 may be permanently or removably affixed to vehicle 102. Sealed subsystem 120 may be removed from vehicle 102 to facilitate recharge or replacement of PCM 128.

The use of PCM 128 to cool subsystems 104, cabin 118, and/or power source 114 of vehicle 102 of system 100 may provide several advantages over TMS and/or other cooling systems used in electric vehicles. PCM 128 may manage instantaneous increases in thermal power without increased volume, weight, and power allocations. PCM 128 may facilitate thermal management of different components and/or subsystem of vehicle 102 via a single cooling system (e.g., via a single heat exchanger 116 and a single sealed subsystem 120). For example, PCM 128 may facilitate maintenance of components of subsystems 104, cabin 118, and/or power source 114 at different temperatures. This eliminates a need for multiple separate cooling systems, thereby reducing volume and weight required to cool the components and/or subsystems of vehicle 102. The use of PCM 128 to manage the temperatures of vehicle 102 may also reduce power requirements to manage the temperatures of vehicle 102 as compared to the use of TMS or other cooling systems.

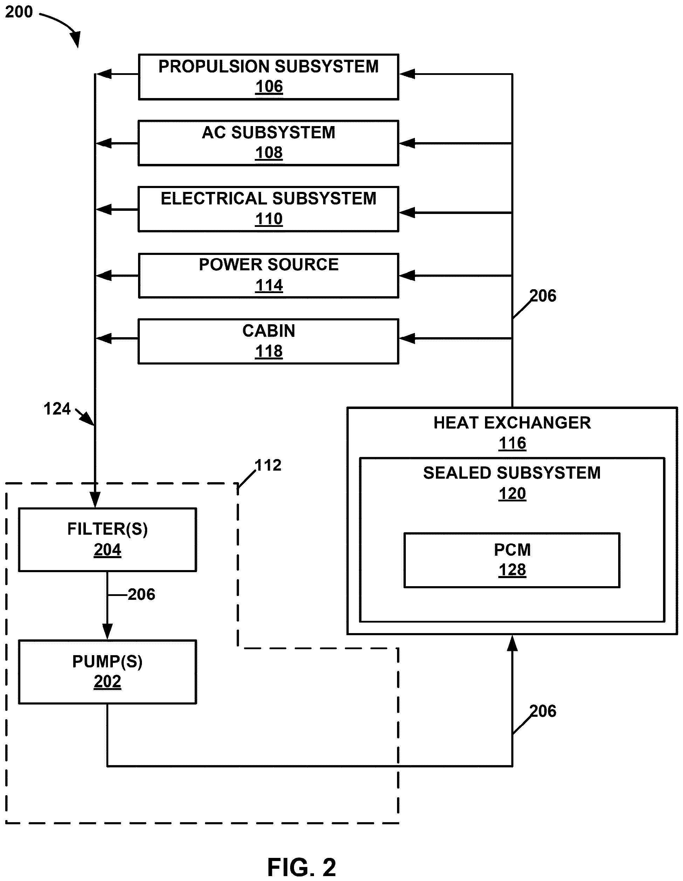

FIG. 2 is a block diagram illustrating an example cooling system 200 for vehicle 102 of FIG. 1. Cooling system 200 may include cooling subsystem 112, heat exchanger 116, and sealed subsystem 120. Cooling system 200 may be thermally coupled to subsystems 104 of vehicle 102 such as propulsion subsystem 106, AC subsystem 108, and/or electrical subsystem 110, to power source 114, to cabin 118, and/or to one or more other components or subsystems within vehicle 102. In some examples, subsystems 104 and power source 114 may define an EAP system of vehicle 102.

As illustrated in FIG. 2, cooling subsystem 112 may include one or more pump(s) 202, one or more filters 204, and channels 206. Cooling subsystem 112 may circulate a temperature moderating medium (e.g., air, another gas, a liquid) through cooling system 200 via channels 206 to transfer thermal energy 124 from subsystems 104, power source 114, and/or cabin 118 and into PCM 128 within sealed subsystem 120 via heat exchanger 116.

Pump(s) 202 may circulate the temperature moderating medium through channels 206 within cooling system 200. Pump(s) 202 may circulate the temperature moderating medium away from subsystems 104, power source 114, and/or cabin 118 and into heat exchanger 116 to transfer thermal energy 124 into heat exchanger 116 via the temperature moderating medium. Pump(s) 202 may than circulate the temperature moderating medium from heat exchanger 116 back into and/or around subsystems 104, power source 114, and/or cabin 118.

Filter(s) 204 may be disposed along channels 206 and may be disposed upstream of pump(s) 202, heat exchanger 116, one or more subsystems 104, power source 114, and/or cabin 118. Filter(s) 204 may remove debris, corrosion, or from within the temperature moderating medium and may maintain a cleanliness of the temperature moderating medium. Filter(s) 204 may provide an indication of a need to service or replace components of cooling system 200 and/or a need to replace temperature moderating medium within cooling system 200.

Channels 206 may thermally couple cooling subsystem 112 to heat exchanger 116 and to subsystems 104, power source 114, and/or cabin 118. Channels 206 may contain and direct the flow of temperature moderating medium within cooling system 200. Channels 206 may include one or more valves disposed within channels 206. The valves may be disposed upstream of pump(s) 202, heat exchanger 116, one or more subsystems 104, power source 114, and/or cabin 118. The one or more valves may facilitate travel of temperature moderating medium within cooling system 200 in a single direction (e.g., in a counter-clockwise direction as shown in FIG. 2) to maintain the temperatures of subsystem 104, power source 114, and/or of cabin 118.

Each of subsystems 104, power source 114, and/or cabin 118 may be thermally coupled to heat exchanger 116 via a single common channel 206 of channels 206 or via separate channels 206. The temperature moderating medium may flow across a surface of heat exchanger 116 and transmit thermal energy 124 through heat exchanger 116 and into a second, separate temperature moderating medium thermally coupled to sealed subsystem 120. The second temperature moderating medium may then transmit thermal energy 124 into PCM 128 within sealed subsystem 120. PCM 128 may function as a thermal reservoir for thermal energy 124.

Channels 206 may direct temperature moderating medium from heat exchanger 116 to re-enter into and/or around components and/or subsystems of vehicle 102 (e.g., subsystems 104, power source 114, and/or cabin 118). When the first temperature moderating medium re-enters components and/or subsystems, the temperature moderating medium may be at a specified temperature corresponding to the component and/or subsystem. The specified temperatures for different components and/or subsystems may be different.

PCM 128 may act as a reservoir of thermal energy within cooling system 200 and may store or release thermal energy 124 in response to transient changes in temperatures in one or more of subsystems 104, power source 114, and/or cabin 118. In some examples, where cooling system 200 is cooling one or more components and/or subsystems, temperature modulating medium may transfer thermal energy 124 into sealed subsystem 120 via heat exchanger 116 in response to increases in temperature. In some examples, where cooling system 200 is increasing the temperature of one or more components and/or subsystems, sealed subsystem 120 may transfer thermal energy 124 stored in PCM 128 into temperature modulating medium within channels 206 via heat exchanger 116 in response to decreases in temperature.

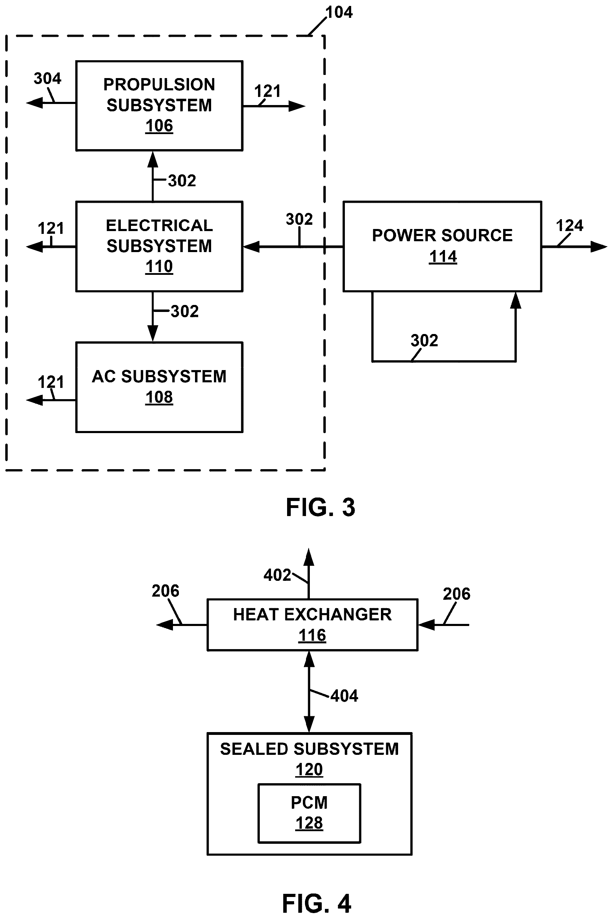

FIG. 3 is a block diagram illustrating the flow of energy within subsystems 104 of example electric vehicle 102 of FIG. 1. As illustrated in FIG. 3, propulsion subsystem 106 and/or AC subsystem 108 may be electrically coupled to power source 114 and may retrieve electrical energy 302 from power source 114 to perform any of the functions previously described above. Electrical subsystem 110 may draw electrical energy 302 from power source 114 and transmit electrical energy 302 to other subsystems of subsystems 104 (e.g., to propulsion subsystem 106 an AC subsystem 108, as illustrated in FIG. 3) to cause the other subsystems to perform the corresponding functions as described herein. For example, electrical subsystem 110 transmits electrical energy 302 to propulsions subsystem 106 to cause propulsion subsystem 106 to generate propulsion 304 used to propel vehicle 102. In another example, electrical subsystem 110 transmits electrical energy 302 to AC subsystem 108 to cause AC subsystem 108 to regulate the temperature of cabin 118 within vehicle 102. Power source 114 may internally circulate electrical energy 302 to maintain the functions of power source 114 and/or to continuously provide electrical energy 302 to electrical subsystem 110.

As a byproduct of operations by subsystems within subsystems 104 and/or power source 114, some of the components and/or subsystems constituting subsystems 104 and/or power source 114 main generate thermal energy. For example, propulsion subsystem 106, AC subsystem 108, and electrical subsystem 110 may generate thermal energy 121 during operations. Similarly, power source 114 may generate thermal energy 124 during operations. Cooling system 200, as illustrated in FIG. 2, may regulate the temperature of components and/or subsystems constituting subsystems 104 and/or power source 114 and deposit excess thermal energy 121, thermal energy 124 within PCM 128.

FIG. 4 is a block diagram illustrating the exchange of thermal energy between heat exchanger 116 and PCM 128 within system 100 of FIG. 1. As illustrated in FIG. 4, heat exchanger 116 may be thermally coupled to sealed subsystem 120 via channels 404. In such examples, heat exchanger 116 may transfer thermal energy 124 from a first temperature moderating medium within channels 206 into a second temperature moderating medium within channels 404. The second temperature moderating medium may be circulated into and/or around sealed subsystem 120 and transfer the thermal energy into PCM 128 within sealed subsystem 120. In other examples, heat exchanger 116 may be integral or affixed to sealed subsystem 120 and may transmit thermal energy directly into sealed subsystem 120.

Heat exchanger 116 fluidically separates the first temperature moderating medium within channels 206 from the second temperature moderating medium within channels 404. The first temperature moderating medium and the second temperature moderating medium may be at different temperatures, e.g., to facilitate transfer of thermal energy 124 between the temperature moderating mediums. The first temperature moderating medium may transmit thermal energy through heat exchanger 116 and into the second temperature moderating medium due to the difference in temperature. Heat exchanger 116 may define one or more channels configured to facilitate flow of the first temperature moderating medium and one or more other channels configured to facilitate flow of the second temperature moderating medium, e.g., to allow for the transfer of thermal energy 124 through heat exchanger 116. Cooling system 200 may transmit thermal energy 124 between temperature moderating mediums and heat exchanger 116 via conduction.

Heat exchanger 116 may be actively or passively cooled during a voyage to further increase cooling capabilities of system 100. Heat exchanger 116 may be at least partially exposed to external air flow to facilitate the transfer of thermal energy 402 out of heat exchanger 116 and vehicle 102. In some examples, the transfer of thermal energy 402 may at least partially facilitate re-charge of PCM 128 back to an initial state. In some examples, system 100 directs external air flow over sealed subsystem 120 to facilitate re-charge of PCM 128 back to an initiate state.

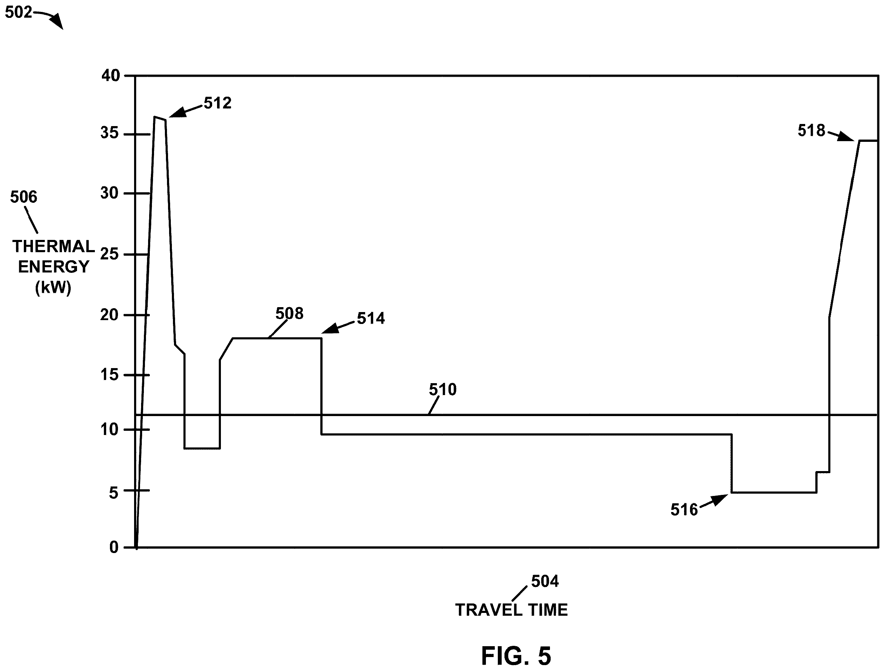

FIG. 5 is a graph 502 illustrating an example thermal power on electric vehicle 10-2 of FIG. 1 over time. Graph 502 illustrates an example heat delivery profile illustrating example changes in thermal power 506 (e.g., in kilowatts (kW)) over travel time 504. Thermal power 506 may define a rate at which thermal energy (e.g., thermal energy 121, 122, 124) changes over time. Vehicle 102 may experience an actual thermal power 508 over time 504 which may be used to determine an average thermal power 510 over time 504.

As illustrated in FIG. 5, actual thermal power 508 may include instantaneous increases in thermal power and instantaneous decreases in thermal power. Increased thermal power 512, 518 may occur at the start and end of a voyage and may be a result of increased thermal energy generated during take-off and landing of vehicle 102 (e.g., during take-off and landing of an eVTOL). During take-off and landing, propulsion subsystem 106 may need to increase output to lift vehicle 102 from the ground or land vehicle 102 on the ground, thereby resulting in instantaneous and localized increased thermal power 512, 518 for the duration of take-off and landing. During the course of a voyage, vehicle 102 may experience increased thermal power 514 and/or decreased thermal power 516. Increased thermal power 514 and decreased thermal power 516 may be a result of, but is not limited to, environmental conditions, change in output of one or more components and/or subsystems within vehicle 102, speed and/or acceleration of vehicle 102, or any other factors capable of causing components and/or subsystems of vehicle 102 to experience a change in thermal power 506. Increased thermal power 512, 514, 518 may be up to, about, or greater than one hundred and fifty percent of average thermal power 508.

TMS and other cooling systems configured to regulate thermal power 506 corresponding to average thermal power 510 may not be capable of regulating increased thermal power 512, 514, or 518. Therefore, vehicle 102 requires TMS of greater volume, weight, and/or power consumption to regulate thermal power 506 corresponding to increased thermal power 512, 514, or 518. PCM 128 may be configured to regulate thermal power 506 within vehicle 102 at both the average thermal power 510 and at increased thermal power 512, 514, and 518 without requiring increased volume, weight, and/or power consumption. Since PCM 128 acts as a thermal reservoir, PCM 128 may simply absorb the increased thermal power 506 during increased thermal power 512, 514, and 518 and, unlike TMS, would not require additional volume, weight, and/or power to manage the increased thermal power 506. During periods of decreased thermal power 516, PCM 128 may retain the stored thermal power 506 and/or may release stored thermal energy 508 to increase the temperature of components and/or subsystems within vehicle 102 to respective minimum operating temperatures.

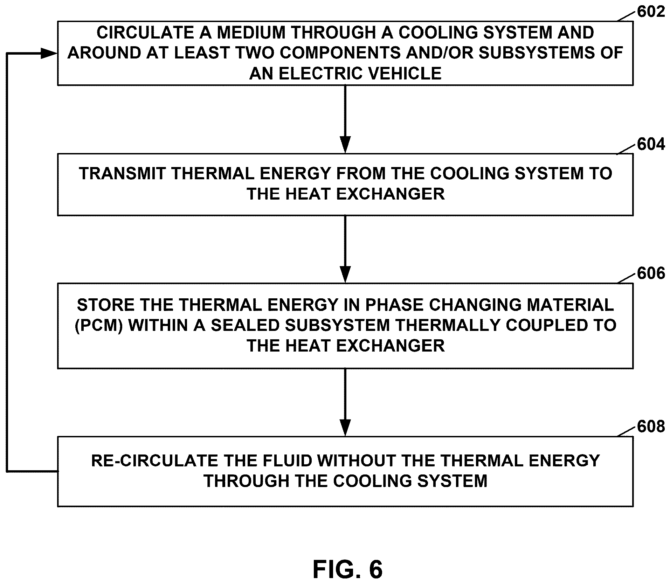

FIG. 6 is a flow chart illustrating an example process of managing the thermal energy of an electric vehicle 102 using PCM 128. While FIG. 6 is primarily described with respect to cooling components and/or subsystems within vehicle 102 by storing thermal energy in PCM 128, system 100 may perform the same process to retrieve thermal energy from within PCM 128 and heat one or more components and/or subsystems within vehicle 102.

System 100 may circulate a medium through a cooling system 200 and around at least two components and/or subsystems of an electric vehicle 102 (602). The medium may be any temperature moderating medium including, but is not limited to, air, another gas, water, or another liquid. The temperature moderating medium may receive thermal energy (e.g., thermal energy 121, thermal energy 122) from components and/or subsystems within vehicle 102. Cooling system 200 may include channels 206 thermally coupled to components and/or subsystems within vehicle 102. System 100 may circulate the medium through cooling system 200 and around the components and/or subsystems via pump(s) 204 within cooling system 200. Components and/or subsystems of vehicle 102 may include, but are not limited to, one or more of subsystems 104, one or more of subsystems 104 constituting an EAP system, power source 114, and/or a cabin 118 of vehicle 102.

System 100 may transmit thermal energy (e.g., thermal energy 124) from cooling system 200 to heat exchanger 116 (604). Cooling system 200 (e.g., channels 206 within cooling system 200) may be configured to circulate the medium through heat exchanger 116. System 100 may circulate the temperature modulating medium through heat exchanger 116, allowing the medium to transmit thermal energy into heat exchanger 116 through contact between the medium and a surface of heat exchanger 116. System 100 may direct temperature modulation medium from different components and/or subsystems of vehicle 102 into a same portion of heat exchanger 116 or into different portions of heat exchanger 116.

System 100 may store the thermal energy in PCM 128 within sealed subsystem 120 thermally coupled to heat exchanger 116 (606). PCM 128 may transition between first state of matter and a second state of matter in response to the inflow or outflow of thermal energy into PCM 128. For example, PCM 128 at least partially transitions from a solid to a liquid in response to inflow of thermal energy (e.g., thermal energy 124) into PCM 128. PCM 128 may function as a thermal reservoir and store the thermal energy from components and/or subsystems of vehicle 102 into PCM 128. PCM 128 may store the thermal energy and maintain each of the two or more components and/or subsystems of vehicle 102 at different temperatures. For example, PCM 128 may maintain cabin 118 of vehicle 102 at a first temperature and power source 114 of vehicle 102 at a second, different temperature.

Sealed subsystem 120 may isolate PCM 128 from other components of vehicle 102 and facilitate removal, installation, and/or maintenance of PCM 128. PCM 128 may be re-charged back to an initial state of matter prior to, during, and/or after a voyage. For example, when vehicle 102 is a eVTOL, system 100 may deliver external air flow over heat exchanger 116 and/or sealed subsystem 120 to at least partially re-charge PCM 128.

System 100 may re-circulate the medium without the thermal energy through cooling system 200 (608). System 100 may direct the medium through cooling system 200 and into and/or around components and/or subsystems of vehicle 102 to continue to regulate thermal energy within the components and/or subsystems. In some examples, where different components and/or subsystems are maintained at different temperatures, system 100 may direct medium corresponding to each of the different components and/or subsystems to the respective components and/or subsystem via separate channels 206.

A "vehicle" may be an aircraft, a land vehicle such as an automobile, or a water vehicle such as a ship or a submarine. An "aircraft" as described and claimed herein may include any fixed-wing or rotary-wing aircraft, airship (e.g., dirigible or blimp buoyed by helium or other lighter-than-air gas), suborbital spaceplane, spacecraft, expendable or reusable launch vehicle or launch vehicle stage, or other type of flying device. An "aircraft" as described and claimed herein may include any crewed or uncrewed craft (e.g., uncrewed aerial vehicle (UAV), flying robot, or automated cargo or parcel delivery drone or other craft).

The following examples may illustrate one or more of the techniques of this disclosure.

Example 1: a system comprising: a heat exchanger configured to be thermally coupled to a cooling system of an electrified aircraft propulsion (EAP) system, wherein the cooling system is thermally coupled to at least two subsystems of a plurality of subsystems of the EAP system, wherein each subsystem of the at least two subsystems is configured to be maintained at a different threshold temperature level; a sealed subsystem thermally coupled to the heat exchanger; and a phase changing material (PCM) disposed within the sealed subsystem, wherein the PCM is configured to transition, via an at least partial transition between a first state of matter and a second state of matter, thermal energy between the PCM and the cooling system via the heat exchanger to maintain each subsystem of the at least two subsystems at a respective threshold temperature level.

Example 2: the system of example 1, wherein the EAP system is disposed within a vehicle, and wherein the at least two subsystems comprises: a power source of the vehicle; and one or more of: a propulsion subsystem of the vehicle; an electrical subsystem of the vehicle; or an air conditioning (AC) subsystem of the vehicle.

Example 3: the system of example 1, wherein the EAP system is disposed within a vehicle, and wherein the at last two subsystems comprises two or more of: a power source of the vehicle; a propulsion subsystem of the vehicle; an electrical subsystem of the vehicle; or an AC subsystem of the vehicle.

Example 4: the system of any of examples 1-3, wherein the EAP system is disposed within a vehicle, wherein the heat exchanger is configured to be thermally coupled to a cabin of a vehicle, and wherein the heat exchanger is configured to maintain a temperature inside the cabin at a threshold cabin temperature level.

Example 5: the system of any of examples 1-4, wherein the heat exchanger is configured to disengage from the cooling system.

Example 6: the system of any of example 1-5, wherein the PCM comprises one or more of a salt hydrate, Paraffin, or a water/ice mix.

Example 7: the system of any of examples 1-6, wherein the sealed subsystem is configured to recharged by cooling an exterior of the heat exchanger, wherein when the sealed subsystem is at least partially recharged, the PCM at least partially reverts back to an initial state of matter.

Example 8: the system of example 7, wherein the exterior of the heat exchanger is configured to be cooled by ambient air or liquid.

Example 9: the system of any of examples 1-8, wherein the EAP system experiences a heat load defining a heat delivery profile, a second portion having a second peak thermal power less than the average thermal power over the heat delivery profile, and a third portion having a third peak thermal power greater than the average thermal power over the heat delivery profile, and wherein the heat exchanger is configured to maintain each subsystem of the at least two subsystems at the respective threshold temperature levels across each of the first portion, the second portion, and the third portion.

Example 10: the system of example 9, wherein at least one of the first peak thermal power or the third peak thermal power is greater than or equal to one hundred and fifty percent of the average thermal power.

Example 11: the system of any of examples 1-10, wherein the first state of matter comprises a solid and the second state of matter comprises a liquid.

Example 12: a method comprising: circulating a fluid within a cooling system of an electrified aircraft propulsion (EAP) system to extract thermal energy from each subsystem of at least two subsystems of a plurality of subsystems of the EAP system; transmitting the thermal energy from the cooling system to a heat echanger thermally coupled to the cooling system; and storing the thermal energy in a phase changing material (PCM) disposed within a sealed subsystem thermally coupled to the heat exchanger, wherein storage of the thermal energy in the PCM at least partially transitions the PCM from a first state of matter to a second state of matter, and wherein storing the thermal energy in the PCM causes the cooling system is configured to maintain each subsystem at a different threshold temperature level.

Example 13: the method of example 12, wherein the EAP system is disposed within a vehicle, and wherein the at least two subsystems comprises: a power source of the vehicle; and one or more of: a propulsion subsystem of the vehicle; an electrical subsystem of the vehicle; or an air conditioning (AC) subsystem of the vehicle.

Example 14: the method of example 12, wherein the EAP system is disposed within a vehicle, and wherein the at least two subsystems comprises two or more of: a power source of the vehicle; a propulsion subsystem of the vehicle; an electrical subsystem of the vehicle; or an AC subsystem of the vehicle.

Example 15. The method of any of examples 12-14, wherein the EAP system is disposed within a vehicle, wherein the heat exchanger is thermally coupled to a cabin of a vehicle, and wherein the method further comprises: causing the heat exchanger to transmit cabin thermal energy from within the cabin of the vehicle to the sealed subsystem to maintain a temperature inside the cabin at a threshold cabin temperature level.

Example 16: the method of any of examples 12-15, wherein PCM comprises one or more of a salt hydrate, Paraffin, or a water/ice mix.

Example 17: the method of any of examples 12-16, further comprising at least partially recharging the sealed subsystem via cooling an exterior of the heat exchanger, wherein recharging the sealed subsystem at least partially reverts the PCM to an initial state of matter.

Example 18: the method of any of examples 12-17, wherein the first state of matter comprises a solid and the second state of matter comprises a liquid.

Example 19: a system comprising: a heat exchanger configured to be thermally coupled to a cooling system of a vehicle, wherein the cooling system is thermally coupled to at least two subsystems of the vehicle, wherein the at least two subsystems comprises two or more of a battery, a propulsion subsystem; an electrical subsystem; an air conditioning (AC) subsystem, or a cabin of the vehicle, wherein each subsystem of the at least two subsystems is configured to be maintained at a different threshold temperature level; a sealed subsystem thermally couple to the heat exchanger; and a phase changing material (PCM) disposed within the sealed subsystem, wherein the PCM is configured to transition, via an at least partial transition between a first state of matter and a second state of matter, thermal energy between the PCM and the cooling system via the heat exchanger to maintain each subsystem of the at least two subsystems at a respective threshold temperature level.

Example 20: the system of example 19, wherein the first state of matter comprises a solid and the second state of matter comprises a liquid.

Various illustrative aspects of the disclosure are described above. These and other aspects are within the scope of the following claims.

## Claims

1. A system comprising:
a heat exchanger configured to be thermally coupled to a cooling system of an electrified aircraft propulsion (EAP) system, wherein the cooling system is thermally coupled to at least two subsystems of a plurality of subsystems of the EAP system, wherein each subsystem of the at least two subsystems is configured to be maintained at a different threshold temperature level;
a sealed subsystem thermally coupled to the heat exchanger; and
a phase changing material (PCM) disposed within the sealed subsystem, wherein the PCM is configured to transition, via an at least partial transition between a first state of matter and a second state of matter, thermal energy between the PCM and the cooling system via the heat exchanger to maintain each subsystem of the at least two subsystems at a respective threshold temperature level.

2. The system of claim 1, wherein the EAP system is disposed within a vehicle, and wherein the at least two subsystems comprises:
a power source of the vehicle; and
one or more of:
a propulsion subsystem of the vehicle;
an electrical subsystem of the vehicle; or
an air conditioning (AC) subsystem of the vehicle.

3. The system of any of claims 1 or 2, wherein the EAP system is disposed within a vehicle, and wherein the at least two subsystems comprises two or more of:
a power source of the vehicle;
a propulsion subsystem of the vehicle;
an electrical subsystem of the vehicle; or
an AC subsystem of the vehicle.

4. The system of any of claims 1-3, wherein the EAP system is disposed within a vehicle, wherein the heat exchanger is configured to be thermally coupled to a cabin of a vehicle, and wherein the heat exchanger is configured to maintain a temperature inside the cabin at a threshold cabin temperature level.

5. The system of any of claims 1-4, wherein the heat exchanger is configured to disengage from the cooling system.

6. The system of any of claims 1-5, wherein the PCM comprises one or more of a salt hydrate, Paraffin, or a water/ice mix.

7. The system of any of claims 1-6, wherein the sealed subsystem is configured to be recharged by cooling an exterior of the heat exchanger, wherein when the sealed subsystem is at least partially recharged, the PCM at least partially reverts back to an initial state of matter.

8. The system of claim 7, wherein the exterior of the heat exchanger is configured to be cooled by ambient air or liquid.

9. The system of any of claims 1-8,
wherein the EAP system experiences thermal power defining a thermal delivery profile including a first portion having a first peak thermal power greater than an average thermal power over the heat delivery profile, a second portion having a second peak thermal power less than the average thermal power over the heat delivery profile, and a third portion having a third peak thermal power greater than the average thermal power over the heat delivery profile, and
wherein the heat exchanger is configured to maintain each subsystem of the at least two subsystems at the respective threshold temperature levels across each of the first portion, the second portion, and the third portion.

10. The system of claim 9, wherein at least one of the first peak thermal power or the third peak thermal power is greater than or equal to one hundred and fifty percent of the average thermal power.

11. The system of any of claims 1-10, wherein the first state of matter comprises a solid and the second state of matter comprises a liquid.

12. A method comprising:
circulating a fluid within a cooling system of an electrified aircraft propulsion (EAP) system to extract thermal energy from each subsystem of at least two subsystems of a plurality of subsystems of the EAP system;
transmitting the thermal energy from the cooling system to a heat exchanger thermally coupled to the cooling system; and
storing the thermal energy in a phase changing material (PCM) disposed within a sealed subsystem thermally coupled to the heat exchanger,
wherein storage of the thermal energy in the PCM at least partially transitions the PCM from a first state of matter to a second state of matter, and wherein storing the thermal energy in the PCM causes the cooling system is configured to maintain each subsystem at a different threshold temperature level.

13. The method of claim 12, wherein the EAP system is disposed within a vehicle, and wherein the at least two subsystems comprises:
a power source of the vehicle; and
one or more of:
a propulsion subsystem of the vehicle;
an electrical subsystem of the vehicle; or
an air conditioning (AC) subsystem of the vehicle.

14. The method of any of claims 12 or 13, wherein the EAP system is disposed within a vehicle, and wherein the at least two subsystems comprises two or more of:
a power source of the vehicle;
a propulsion subsystem of the vehicle;
an electrical subsystem of the vehicle; or
an AC subsystem of the vehicle.

15. The method of any of claims 12-14, wherein the EAP system is disposed within a vehicle, wherein the heat exchanger is thermally coupled to a cabin of a vehicle, and wherein the method further comprises:
causing the heat exchanger to transmit cabin thermal energy from within the cabin of the vehicle to the sealed subsystem to maintain a temperature inside the cabin at a threshold cabin temperature level.
